(19) **Europäisches Patentamt / European Patent Office / Office européen des brevets**

(11) **EP 2 938 569 B1**

(12) **FASCICULE DE BREVET EUROPEEN**

(45) Date de publication et mention
de la délivrance du brevet:
**04.09.2019 Bulletin 2019/36**

(21) Numéro de dépôt: **13821889.6**

(22) Date de dépôt: **24.12.2013**

(51) Int Cl.:
**B81B 3/00** *(2006.01)*  **G01P 15/08** *(2006.01)*
**G01P 15/12** *(2006.01)*  **G01P 15/125** *(2006.01)*

(86) Numéro de dépôt international:
**PCT/FR2013/053265**

(87) Numéro de publication internationale:
**WO 2014/102507 (03.07.2014 Gazette 2014/27)**

(54) **DISPOSITIF MICRO-ELECTROMECANIQUE COMPRENANT UNE MASSE MOBILE APTE A SE DEPLACER HORS DU PLAN**

MIKROELEKTROMECHANISCHE VORRICHTUNG MIT EINER IN DREI DIMENSIONEN BEWEGLICHEN MASSE

MICRO-ELECTROMECHANICAL DEVICE COMPRISING A MOBILE MASS THAT CAN MOVE OUT-OF-PLANE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.12.2012 FR 1262882**

(43) Date de publication de la demande:
**04.11.2015 Bulletin 2015/45**

(73) Titulaires:
- **Tronic's Microsystems**
  **38920 Crolles (FR)**
- **Commissariat à l'Énergie Atomique et aux Énergies Alternatives**
  **75015 Paris (FR)**

(72) Inventeurs:
- **BOILLOT, François-Xavier**
  **F-35000 Rennes (FR)**
- **LAOUBI, Rémi**
  **F-73290 La Motte Servolex (FR)**
- **JOURDAN, Guillaume**
  **F-38000 Grenoble (FR)**

(74) Mandataire: **Cabinet Laurent & Charras**
**Le Contemporain**
**50 Chemin de la Bruyère**
**69574 Dardilly Cedex (FR)**

(56) Documents cités:
**EP-A1- 2 211 185    EP-A1- 2 367 015**

**Description**

**DOMAINE DE L'INVENTION**

La présente invention se rapporte à des systèmes micro-électromécaniques, autrement appelés MEMS pour « Micro-ElectroMechanical Systems ». Elle concerne plus particulièrement une structure micro-électromécanique de type capteur de force dans lequel les jauges et éléments déformables constitutifs du capteur sont protégés des ruptures pouvant survenir suite à des contraintes mécaniques fortes exercées sur ledit capteur de force.

L'invention trouve notamment application, par exemple, dans les accéléromètres, les gyromètres, et les magnétomètres, voire les capteurs de pression, et plus généralement tout dispositif dans lequel on souhaite mesurer un déplacement d'une portion mobile consécutif à l'application de forces de diverses natures.

**ETAT DE LA TECHNIQUE**

Depuis l'apparition de techniques sophistiquées de gravure et croissance utilisées notamment par l'industrie micro-électronique, la possibilité de fabriquer des machines ou des capteurs micro- et nano-électromécaniques est devenue une réalité. Ces dispositifs suscitent un fort intérêt en vertu de leurs applications multiples, aussi bien dans le domaine des capteurs, des émetteurs, des actionneurs ou des dispositifs passifs. Ils sont par exemple utilisés dans l'industrie automobile, l'industrie aéronautique ou les téléphones portables, en remplacement de dispositifs macroscopiques plus volumineux.

Parmi les capteurs micro-électromécaniques, les capteurs de force, comme par exemple les accéléromètres, les gyromètres ou les magnétomètres, se déclinent typiquement sous la forme de dispositifs comprenant une masse mobile, et des moyens de détection mesurant les déplacements de cette masse mobile sous l'effet d'une force.

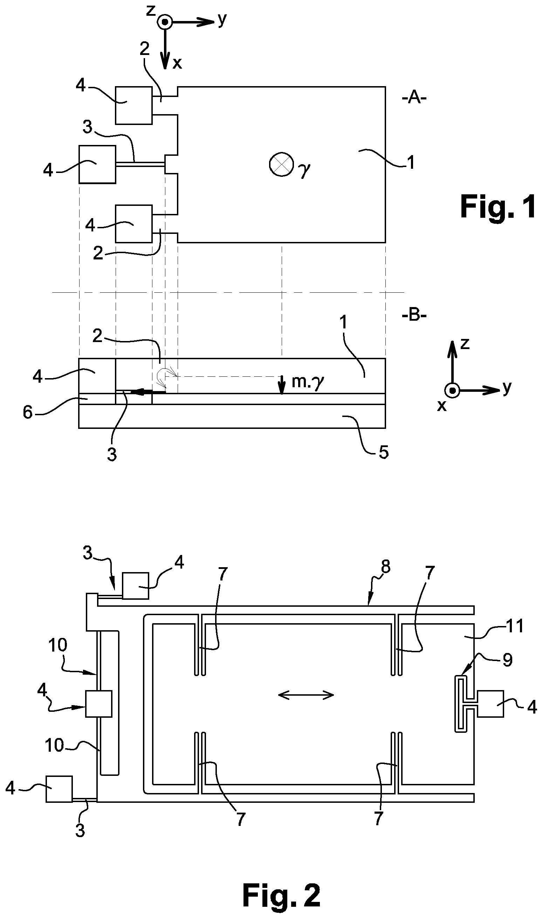

Comme représenté sur la figure 1, la masse mobile **1** d'un capteur de force se présente généralement sous la forme d'une couche de matériau semi-conducteur, et en particulier de silicium d'épaisseur de l'ordre d'une ou plusieurs dizaines de microns, et maintenue au-dessus d'un substrat **5** par des éléments **2**, déformables en flexion ou torsion, autour d'un axe de pivotement. Ces éléments déformables **2** sont souvent appelés ressorts, et sont avantageusement situés au niveau d'une des extrémités latérales de la masse mobile **1.** Les ressorts **2** sont eux-mêmes reliés à des zones d'ancrage **4** fixes liées au substrat. On définit par la suite trois axes x, y, z, tels que représentés sur la figure 1, avec l'axe x orienté suivant l'axe de pivotement de la masse mobile **1**, l'axe y orienté dans le plan de la masse mobile **1** au repos et perpendiculairement à l'axe x, et l'axe z orienté perpendiculairement au plan défini par la masse mobile **1** au repos et partant du substrat **5** vers la masse mobile **1.** Avantageusement, ce type de dispositif est réalisé à partir d'un substrat de type silicium sur isolant (aussi appelé SOI), une couche électriquement isolante d'oxyde **6** séparant la couche de silicium, à partir de laquelle la masse mobile **1** est gravée, et le substrat **5.**

Les détecteurs du mouvement de la masse mobile se présentent d'ordinaire sous la forme de systèmes capacitifs, dans lesquels les déplacements de la masse mobile provoquent un éloignement ou un rapprochement entre deux électrodes du système capacitif, conduisant à une variation de l'entrefer et donc de la capacité du système décrit. Un exemple de tels détecteurs est disponible dans le document US 4736629. Alternativement, il existe des capteurs de force employant une ou plusieurs jauges piézorésistives **3** sensibles en compression et en traction aux déplacements de la masse mobile **1**, comme celle représentée sur la figure 1. Dans les deux cas, la sensibilité du capteur de force est déterminée par l'amplitude du déplacement autorisé par la masse mobile, et par le positionnement des détecteurs du mouvement de la masse mobile. Il est également possible d'utiliser des résonateurs mécaniques en guise de jauges de contrainte, les fréquences de résonance des résonateurs changeant en fonction des contraintes qui leur sont appliquées.

Le placement des jauges piézorésistives **3** est avantageusement choisi de manière à augmenter le plus possible les contraintes en compression et traction subies par les jauges **3**. L'objectif d'une telle opération est d'augmenter la sensibilité en détection du capteur de force.

En effet, les contraintes générées par les déformations en compression/traction, dans les jauges **3** induisent une variation de la résistance des jauges **3** proportionnelle aux contraintes. En mettant une jauge piézorésistive **3** sous tension il est alors possible de détecter la variation de résistance associée, qui est induite par le déplacement de la masse mobile **1** et proportionnelle à la déformation subie. Le déplacement de la masse mobile **1** étant lié à une force extérieure exercée sur elle, l'emploi de jauges de contrainte piézorésistives permet de connaître la valeur d'une force à partir d'une mesure de variation de résistance. Plus la variation de résistance par unité de force est grande, plus le capteur de force micro-électromécanique est sensible.

Les capteurs de force à jauges piézorésistives **3** à déplacement hors du plan de la masse mobile, comme ceux décrits par exemple dans les documents FR 2954505 et FR 2941533 invitent naturellement à placer les jauges piézorésistives **3** dans le prolongement des faces supérieures et/ou inférieures de la masse mobile suivant l'axe z, au voisinage d'un point d'ancrage, de manière à subir des compressions et tractions maximales sans toutefois dépasser un seuil de rupture, comme représenté sur la figure 1.

Il est cependant possible qu'une masse mobile **1** subisse des sollicitations mécaniques engendrant des déplacements dans le plan, suivant les axes x et/ou y. De tels déplacements peuvent conduire à des déformations irréversibles des jauges de contrainte **3**, rendant ainsi inutilisable le capteur de force. Pour contrer cet inconvénient, et comme proposé dans le brevet FR 2941533, il est avantageux de restreindre les déplacements de la masse mobile **1** dans le plan défini par les axes x et y, en combinant des éléments déformables **2** en torsion avec des éléments déformables en flexion, ces deux types d'éléments déformables étant déformables autour de l'axe x. En effet, les éléments déformables en torsion confèrent une bonne résistance aux déplacements suivant l'axe x tout en étant fragiles vis-à-vis des déplacements suivant l'axe y. Concomitamment, les éléments déformables en flexion confèrent une bonne résistance aux déplacements suivant l'axe y tout en étant fragiles vis-à-vis des déplacements suivant l'axe x. Ainsi, les deux types d'éléments déformables **2** offrent des résistances complémentaires, à la fois aux déplacements suivant x et suivant y, permettant de protéger les jauges de contrainte **3**.

Néanmoins, cette combinaison d'éléments déformables présente le désavantage de ne pas permettre l'optimisation simultanée de la gamme de mesure et de la gamme mécanique. On entend par gamme de mesure l'ensemble des valeurs de force que le capteur est capable de détecter, et par gamme mécanique l'ensemble des valeurs en dehors duquel la masse mobile se trouve en butée, en l'occurrence sur le substrat. La gamme de mesure est donc incluse dans la gamme mécanique. Idéalement, la limite haute de la gamme mécanique est supérieure de quelques dizaines de pourcents à celle de la gamme de mesure.

Dans le cas d'une combinaison d'éléments déformables en flexion et torsion, la sensibilité mécanique est faible, de telle sorte que la gamme mécanique est largement supérieure à celle de mesure, le ratio entre les deux gammes étant typiquement de 10.

Afin de faire mieux correspondre ces deux gammes, deux solutions sont possibles.

La première solution consiste à rapprocher le substrat de la masse mobile, ce qui, toutes choses égales par ailleurs, diminue la gamme mécanique. Ceci est faisable en diminuant l'épaisseur de la couche d'oxyde séparant la couche dans laquelle la masse mobile est gravée, et le substrat. Mais cette première solution n'est cependant pas suffisante car il existe une limite inférieure, correspondant à une épaisseur de 300nm, en-dessous de laquelle il devient difficile de libérer la couche d'oxyde par des techniques chimiques, et en-dessous de laquelle le risque que la masse mobile ne colle au substrat augmente considérablement.

La deuxième solution pour rapprocher la gamme de mesure de la gamme mécanique est d'augmenter la sensibilité mécanique. Cette dernière, notée $S_m$, correspond au déplacement maximal de la masse mobile suivant l'axe z, par unité de force. Cette grandeur s'exprime en fonction de la force $F$ appliquée à la masse mobile, de la distance $D_g$ entre le centre de gravité de la masse mobile et l'axe de pivotement, de la longueur $L$ de la masse mobile et de la raideur $K$ des éléments déformables grâce à la relation suivante :

$$S_m = \frac{FD_gL}{K}$$

Afin d'augmenter la sensibilité mécanique, on peut augmenter la longueur de la masse mobile, de manière à éloigner non seulement l'axe de pivotement du centre de gravité de la masse mobile, conduisant à une augmentation de $D_g$. Malgré cela, l'augmentation de sensibilité mécanique ainsi obtenue est insuffisante pour faire correspondre les deux gammes.

L'autre levier pour augmenter la sensibilité mécanique est de diminuer la raideur des éléments déformables. Or la raideur des éléments déformables en flexion est supérieure à celle des éléments déformables en torsion, à dimensions égales. Il est donc souhaitable d'opter pour des éléments déformables en torsion pour augmenter la sensibilité mécanique de la masse mobile d'un capteur de force. L'inconvénient résultant de cette démarche réside dans le fait que les jauges de contrainte sont soumises à des sollicitations suivant l'axe y pouvant les endommager de manière irréversible.

Le document EP 2 367 015 décrit un dispositif comportant une masse mobile comportant un cadre périphérique et un corps intérieur. Les déplacements du corps intérieur de la masse mobile ne sont limités que par le fonctionnement des éléments de liaison reliant le corps intérieur et le cadre périphérique.

Ainsi, lorsque le cadre périphérique subit un choc, le corps intérieur entre en contact avec le cadre périphérique. La force du choc est ensuite transmise au substrat par l'intermédiaire des liaisons. Il s'ensuit que cette solution ne permet pas de protéger les éléments de liaison qui constituent des éléments fragiles risquant d'être détruits suite aux force inertielles engendrées lors d'un choc.

Il apparaît alors que l'Homme du métier n'a pas connaissance de solution permettant d'utiliser des éléments déformables de faible raideur, donc avantageusement des éléments déformables en torsion, dans un capteur de force à déplacements hors du plan, qui permette d'avoir une sensibilité mécanique telle que la gamme mécanique soit suffisamment proche de la gamme de mesure, tout en protégeant les jauges de contrainte contre les sollicitations mécaniques liées à l'application de forces transverses, c'est-à-dire dans le plan x-y, et principalement suivant l'axe y, sur la masse mobile.

**EXPOSE DE L'INVENTION**

L'un des buts de la présente invention est de fournir un capteur de force à déplacements hors du plan défini par les axes x et y, résistant aux efforts dans le plan défini par les axes x et y de la masse mobile et présentant une sensibilité mécanique élevée.

Pour y parvenir, la présente invention a pour objet un dispositif micro-électromécanique réalisé à partir d'un substrat semi-conducteur dont les couches définissent des plans suivant des axes x et y, l'axe perpendiculaire aux couches définissant un axe z, ledit dispositif comprenant :

- au moins une zone d'ancrage fixe par rapport au substrat, et
- au moins une masse mobile, apte à se déplacer hors du plan du substrat selon l'axe z par rotation autour d'un axe de pivotement dirigé selon l'axe x, et
- au moins un élément déformable, l'élément déformable reliant la masse mobile à la zone d'ancrage,
- au moins un moyen de détection du déplacement de la masse mobile.

La masse mobile de ce dispositif présente deux parties. Une première partie qui forme une structure porteuse est reliée à la zone d'ancrage par l'élément déformable, et la seconde partie forme le corps principal de la masse mobile. Les première et seconde parties sont reliées par au moins deux portions flexibles formant ressorts de découplage solidaires de deux côtés distincts de la première partie. Le dispositif comporte également au moins une butée limitant les déplacements du corps principal de la masse mobile.

L'utilisation de ressorts de découplage reliant le corps principal formant une masse mobile à la structure porteuse permet de découpler les déplacements, dans le plan, du corps principal de ceux, hors du plan, de la structure porteuse. Par ailleurs, la masse du corps principal est supérieure à celle de la structure porteuse, avantageusement significativement plus grande, de manière à avoir une inertie plus élevée que celle de la structure porteuse. De cette manière, une force appliquée à la masse mobile agit principalement sur le corps principal de la masse mobile.

Ainsi, une force appliquée suivant l'axe y au dispositif provoque un déplacement du corps principal par rapport à la structure porteuse de la masse mobile, dans le plan de la masse mobile. Ce déplacement du corps principal par rapport à la structure porteuse est en particulier lié à une déformation élastique des portions flexibles, ou ressorts de découplage. Les portions flexibles possédant un seuil d'élasticité et un seuil de rupture, on place la butée à une distance telle du corps principal de la masse mobile que ces deux seuils ne soient pas atteints. Autrement dit, la zone formant butée devient effective avant que les ressorts de découplage ne sortent de leur régime de comportement élastique quasi linéaire et avant que les différentes branches des ressorts ne butent l'une sur l'autre. Cela permet ainsi de protéger les organes qui détectent le mouvement de la masse mobile, et qui peuvent n'admettre qu'une amplitude de déformation limitée.

Ainsi, au-delà d'une certaine amplitude de force extérieure appliquée dans le plan de la masse mobile, notamment suivant l'axe y, le corps principal se déplace dans le plan de la masse mobile et suivant l'axe y par rapport à la masse mobile jusqu'à rentrer en contact avec la butée. Dans ce cas, l'énergie liée à ce déplacement sous l'effet de la force extérieure est absorbée par la collision avec la butée. Pour des amplitudes inférieures de force extérieure appliquée dans le plan de la masse mobile, notamment suivant l'axe y, le corps principal de la masse mobile se déplace peu, voire pas du tout, et l'intégralité de l'énergie liée à l'application de la force extérieure au dispositif est dissipée dans les zones d'ancrage.

En pratique, plusieurs géométries sont envisageables pour la disposition relative de la structure porteuse et du corps principal de la masse mobile. Ainsi, la structure porteuse peut former un cadre extérieur entourant le corps principal, qui forme alors le corps intérieur de la masse mobile. A l'inverse, il est également possible que le corps principal soit disposé en périphérie de la structure porteuse, qui forme alors une poutre centrale autour de laquelle est réparti le corps principal.

L'élément déformable reliant la masse mobile à la zone d'ancrage est avantageusement choisi parmi des éléments déformables en torsion afin d'offrir une raideur plus faible et augmenter la sensibilité mécanique du capteur de force. De cette manière, le dispositif objet de l'invention garantit au capteur de force une sensibilité mécanique élevée et protège les jauges de contrainte contre les sollicitations mécaniques dans le plan défini par les axes x et y, et suivant l'axe y principalement.

Diverses géométries sont envisageables pour réaliser les ressorts de découplage. Dans chacun des cas de figure, les ressorts de découplage sont prévus pour avoir une raideur élevée suivant la direction z, permettant ainsi d'assurer un déplacement synchronisé et de même amplitude suivant la direction z du corps principal et de la structure porteuse. En d'autres termes, la raideur suivant z des portions flexibles est telle que le corps principal et la structure porteuse sont en permanence sensiblement dans un même plan. D'autre part, les ressorts de découplage sont aussi prévus pour avoir une raideur faible dans le plan défini par les axes x et y, notamment suivant l'axe y, autorisant des déplacements dans le plan du corps principal par rapport à la structure porteuse. Le découplage assuré par les portions flexibles, ou ressorts de découplage, consiste ainsi à répartir sélectivement les forces extérieures appliquées à la masse mobile. En particulier, les composantes suivant z des forces extérieures appliquées à la masse mobile n'engendrent pas de déformations des portions flexibles tandis que les composantes suivant x et y des forces extérieures appliquées à la masse mobile peuvent engendrer des déformations des portions flexibles.

Ainsi, selon un mode de réalisation, les portions flexibles sont espacées d'une distance selon l'axe y supérieure à la moitié de la longueur selon l'axe y du corps principal de la masse mobile.

Cet espacement entre les portions flexibles ou ressorts de découplage, permet de maintenir le corps principal et la structure porteuse en permanence dans un même plan.

Selon un mode de réalisation, au moins deux portions flexibles s'étendent sur plus de la moitié de la largeur, suivant l'axe x, de la masse mobile.

Cette condition sur la longueur permet d'abaisser la raideur suivant l'axe y des portions flexibles ou ressorts de découplage, sans pour autant abaisser significativement la raideur suivant la direction x de ces ressorts de découplage.

Différentes géométries répondent aux critères établis ci-avant pour les portions flexibles formant des ressorts de découplage.

Ainsi, les portions flexibles peuvent être des poutres déformables en flexion. Cette géométrie simple permet de facilement réaliser des poutres dont les dimensions offrent une raideur élevée suivant l'axe z, et faible suivant l'axe y. De telles poutres possèdent également une raideur élevée suivant l'axe x.

Selon un mode particulier de réalisation, les portions flexibles comportent plusieurs segments consécutifs présentant un angle non nul de l'un à l'autre.

De telles portions flexibles ou ressorts de découplage, sont avantageuses dans la mesure où elles permettent de réduire davantage la raideur du ressort selon une direction privilégiée, notamment selon la direction y, tout en conservant une raideur importante selon l'axe z et d'une façon moindre, selon l'axe x.

Selon un mode de réalisation, le dispositif comprend au moins quatre portions flexibles, lesdites portions flexibles étant disposées deux à deux en regard l'une de l'autre. Cette géométrie permet de rendre le découplage aussi symétrique que possible suivant l'axe y, ce qui se traduit aussi par une répartition plus homogènes des contraintes et une meilleure résistance aux variations de température.

Les butées ancrées dans le substrat et placées en regard du corps intérieur de la masse mobile, à une distance permettant de ne pas atteindre la limite de rupture des portions flexibles ni même avantageusement la limite d'élasticité de ces portions flexibles, peuvent être réalisés de différentes manières.

Ainsi, selon un mode de réalisation, le dispositif objet de l'invention comporte au moins une zone formant une butée pour le corps principal de la masse mobile, la butée étant disposée en regard du côté de la masse mobile situé à l'opposé de la zone d'ancrage.

Différentes formes sont par ailleurs envisageables pour constituer la butée.

Ainsi, selon un premier mode particulier de réalisation, le dispositif peut comporter au moins une zone formant une butée pour le corps principal de la masse mobile, ladite butée étant un pilier ancré sur le substrat et aménagé dans un évidement du corps principal de la masse mobile.

Selon un second mode particulier de réalisation, la butée peut avoir une forme en T en vue de dessus.

Selon un autre mode de réalisation, les flancs latéraux de la butée présentent des parties convexes.

L'existence d'excroissances convexes sur les flancs de la butée et en vis-à-vis de parties convexes sur la masse mobile, permet de minimiser les surfaces de contact entre la masse mobile et la butée, donc les risques de collage, tout en maximisant la robustesse des éléments entrechoqués. Ainsi, les parties convexes en vis-à-vis sur les flancs de la butée et ceux de la masse mobile permettent de répartir l'énergie des chocs mécaniques de manière moins préjudiciable pour l'intégrité du capteur de force.

Plusieurs modes de réalisation sont envisageables pour le positionnement des butées formant des zones d'arrêt pour le corps intérieur de la masse mobile.

Dans un premier cas de figure, il est possible que le corps principal de la masse mobile présente un évidement de forme sensiblement complémentaire à celui de la butée. Autrement dit, la butée est fixe par rapport au substrat, et s'intègre dans un logement prévu à cet effet dans la masse mobile. Avantageusement, on peut prévoir des parties convexes sur les flancs latéraux ou sur la face en regard de l'évidement, en ménageant un espace suffisant pour que les contacts entre la butée et la masse mobile soient les plus ponctuels possible. On assure ainsi une bonne distribution des contraintes, et on limite ainsi les risques de collage, et les risques d'apparition de débris.

Alternativement, dans un autre cas de figure, il est également possible de former la butée solidaire de la masse mobile, et orientée à l'extérieur du corps principal, pour se déplacer dans un évidement réalisé dans une portion fixe du substrat. Il est toujours possible de structurer la butée de manière à ce qu'elle présente des parties convexes même lorsque la butée est ancrée au substrat mais située à l'extérieur du corps principal de la masse mobile.

Afin de guider la masse mobile dans son mouvement selon l'axe z, et pour minimiser les chocs dus aux sollicitations mécaniques selon l'axe x, le dispositif objet de l'invention peut comporter des zones formant des butées latérales agencées en regard des flancs latéraux de la masse mobile.

Avantageusement, les zones formant des butées latérales présentent des excroissances de forme arrondie, de manière notamment à mieux répartir les forces en cas de collision avec la masse mobile, évitant ainsi de l'endommager.

Afin de protéger les jauges des sollicitations mécaniques à la fois suivant l'axe x et suivant l'axe y, il est possible d'agencer au moins deux portions flexibles ou ressorts de découplage orientés suivant des directions perpendiculaires, au moins une première portion flexible étant orientée suivant l'axe x et au moins une seconde portion flexible étant orientée suivant l'axe y.

## DESCRIPTION SOMMAIRE DES FIGURES

L'invention sera mieux comprise à la lecture de la description qui suit, donnée uniquement à titre d'exemple, et réalisée en relation avec les dessins annexés, dans lesquels les mêmes références désignent des éléments identiques ou analogues et dans lesquels :

- les figures 1A et 1B sont des vues du dessus et de côté d'un capteur de force à déplacement hors du plan de l'art antérieur ; et
- la figure 2 est une vue du dessus d'un capteur de force à déplacement hors du plan selon un premier mode de réalisation ; et
- la figure 3 est une vue du dessus d'un capteur de force à déplacement hors du plan selon un second mode de réalisation ; et
- la figure 4 est une vue du dessus d'un ressort de découplage intégré dans le capteur de force à déplacement hors du plan selon le second mode de réalisation ; et
- la figure 5 est une vue du dessus d'un capteur de force à déplacement hors du plan selon un troisième mode de réalisation ; et
- la figure 6 est une vue du dessus d'un capteur de force à déplacement hors du plan selon un quatrième mode de réalisation ; et
- la figure 7 est une vue du dessus d'un capteur de force à déplacement hors du plan selon un cinquième mode de réalisation.
- la figure 8 est une vue du dessus d'un capteur de force à déplacement hors du plan selon un sixième mode de réalisation ; et

Certains éléments de ces figures ont été agrandis pour faciliter leur compréhension et peuvent par conséquent ne pas être à l'échelle.

## DESCRIPTION DETAILLEE DE L'INVENTION

Il va à présent être décrit un dispositif micro-électromécanique formant un capteur de force à déplacements hors du plan permettant de bénéficier d'une sensibilité mécanique accrue tout en protégeant les jauges de contrainte, dédiées à la mesure des déplacements d'une masse mobile, contre les sollicitations mécaniques dues à des déplacements non souhaités de la masse mobile dans le plan formé par les axes x et y. Il sera fait référence à des déplacement dits « hors du plan » pour désigner des déplacements intervenant suivant l'axe z et à des déplacements dits « dans le plan » pour désigner des déplacements intervenant dans le plan défini par les axes x et y.

Comme représenté sur la figure 2, l'invention comprend au moins une zone d'ancrage **4,** liée par des jauges de contrainte **3,** sensibles en compression et traction, et par des éléments déformables en torsion **10,** à une masse mobile qui se décompose en deux parties : une première partie ou structure porteuse, qui est formée d'un cadre extérieur **8** et une seconde partie ou corps principal de la masse mobile, qui est formée d'un corps intérieur **11**. La masse du corps intérieur **11** représente plus de la moitié de la masse totale de la masse mobile. Ce corps intérieur **11** possède ainsi une inertie plus élevée que le cadre extérieur 8. Ces deux parties sont reliées entre elles par l'intermédiaire d'au moins deux éléments déformables en flexion appelés ressorts de découplage 7. Ces ressorts de découplage 7 sont configurés de manière à autoriser un découplage des mouvements du corps intérieur **11** de ceux du cadre extérieur **8** dans le plan; tout en liant fortement les mouvements de ces deux parties hors du plan. Ainsi, le cadre extérieur **8** et le corps intérieur **11** sont en permanence sensiblement dans un même plan, mais les déplacements dans ce même plan du corps intérieur **11** et du cadre extérieur **8** peuvent être différents.

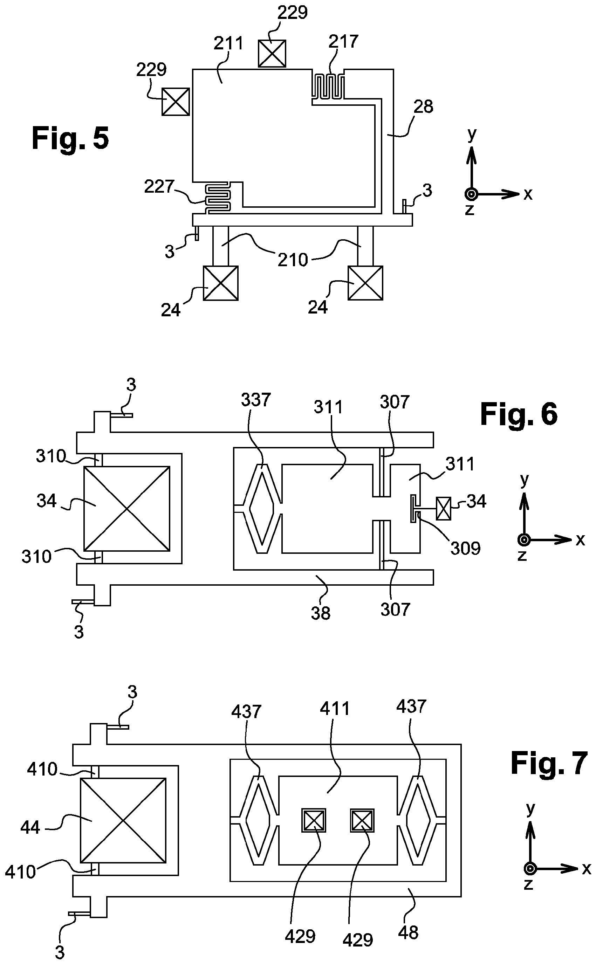

Comme représenté sur la figure 2, le capteur de force objet de l'invention comprend, à l'extrémité opposée à celle comprenant la zone d'ancrage **4** et les éléments déformables en torsion **10,** une zone formant une butée **9,** au contact de laquelle vient le corps intérieur **11** de la masse mobile suite à des forces extérieures et d'amplitude importante, appliquées dans le plan suivant l'axe y. Cette butée **9** comprend un ancrage **4** au substrat, et peut revêtir différentes formes. Sur la figure 2, la butée **9** a une forme en T, en vue de dessus, mais d'autres géométries pour la butée **9** sont envisageables. Sur la figure 7, la butée **9** est disposée à l'intérieur d'un évidement réalisé dans le corps intérieur **11** de la masse mobile. Il est toutefois possible de placer la butée en regard d'un côté du corps intérieur de la masse mobile sans réaliser d'évidement dans le corps intérieur de la masse mobile.

Le corps intérieur **11** rentre en contact avec la butée **9** lorsque les forces extérieures appliquées au système dans le plan sont d'amplitude supérieure à une valeur seuil, déterminée par les propriétés géométriques du dispositif, notamment la masse du corps intérieur **11,** la raideur des ressorts de découplage 7, et la distance séparant le corps intérieur **11** de la butée **9**. Dans ce cas de figure, les ressorts de découplage 7 sont tendus à leur maximum autorisé par la géométrie du dispositif suivant l'axe y, et l'essentiel de l'énergie associée à l'application de la force extérieure suivant y au dispositif est dissipée dans cette collision entre corps intérieur **11** et butée **9**. Le cadre extérieur **8** peut encore subir les effets de la force extérieure suivant y appliquée au dispositif, en dissipant une partie de l'énergie apportée par cette force via les zones d'ancrage **4**. Cependant, les effets de la force extérieure suivant y appliquée au dispositif sur le cadre extérieur **8** sont faibles devant les effets de cette force sur le corps intérieur **11**.

Les ressorts de découplage 7 possèdent une limite élastique, au-delà de laquelle les déformations subies en flexion sont irréversibles, et une limite de rupture, au-delà de laquelle les ressorts de découplage 7 se rompent. La butée **9** est agencée en regard du corps intérieur **11** de la masse mobile à une distance telle que les déformations en flexion des ressorts de découplage 7 soient inférieures à la limite de rupture et avantageusement inférieures à la limite élastique. De cette manière, la durée de vie du capteur de force est allongée.

Il est tout à fait envisageable d'appliquer le même principe afin de protéger un capteur de force contre des forces extérieures appliquées au dispositif suivant l'axe x, sans difficulté pour l'Homme du métier.

Dans le mode de réalisation de la figure 2, les ressorts de découplage 7 sont des poutres déformables en flexion. Les ressorts de découplage **7** sont disposés sur des côtés distincts du corps intérieur **11,** et avantageusement espacés suivant l'axe x et y d'une distance permettant d'empêcher des déformations en torsion des ressorts de découplage **7.** Cette distance correspond avantageusement à au moins la moitié de la longueur totale du corps intérieur **11** de la masse mobile. En effet, un positionnement inadapté des ressorts de découplage **7,** c'est-à-dire des ressorts de découplage **7** trop rapprochés ou disposés sur un même côté du corps intérieur **11,** autoriseraient un découplage des mouvements du corps intérieur **11** et du cadre extérieur **8** hors du plan, faussant ainsi toutes les mesures de déplacement des jauges de contrainte **3.** Selon le mode de réalisation illustré à la figure 2, le capteur de force objet de l'invention présente quatre ressorts de découplage **7,** disposés deux à deux en regard les uns des autres, liant ainsi plus fermement le cadre extérieur **8** au corps intérieur **11,** le cadre extérieur **8** et le corps intérieur **11** étant alors en permanence sensiblement dans un même plan. Il est possible de placer une pluralité de ressorts de découplage 7 entre le corps intérieur **11** et le cadre extérieur **8,** et de disposer les ressorts sans qu'ils ne soient en regard les uns en face des autres.

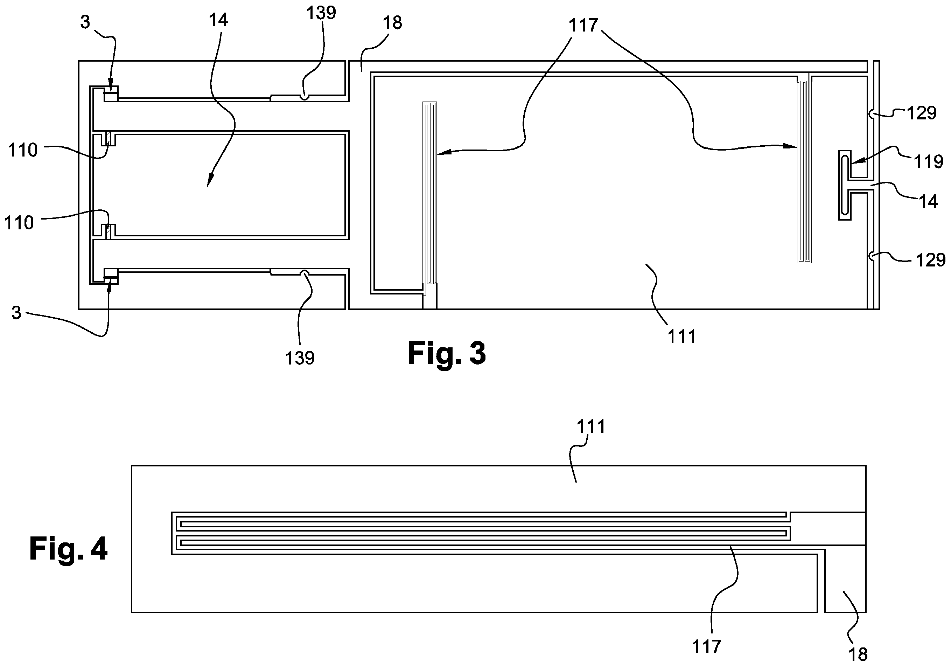

La figure 3 illustre un capteur de force objet de l'invention selon un second mode de réalisation, différent du mode de réalisation de la figure 2 notamment en ce que les ressorts de découplage **117** sont structurés par segments reliés les uns aux autres de manière à former des ondulations en S, conférant à la portion flexible **117** une géométrie en zigzag. Ces ressorts de découplage **117** sont disposés à des extrémités opposées du corps intérieur **111** de la masse mobile, sur des côtés opposés du corps intérieur **111.** Une vue de dessus du ressort de découplage **117** est représentée à la figure 4.

Les ressorts de découplage **117** représentés aux figures 3 et 4 présentent l'avantage d'avoir une raideur faible pour des déformations dans le plan selon l'axe y, et une raideur élevée pour des déformations selon l'axe x ou l'axe z.

Comme illustré sur la figure 3, les ressorts de découplage **117** possèdent une longueur suivant l'axe x supérieure à la moitié de la largeur du corps intérieur **111** de la masse mobile. Ceci permet d'assurer un découplage efficace en offrant une liberté de déformation en flexion suivant l'axe y optimisée.

La forme du cadre extérieur **18** représenté sur la figure 3 diffère de celle du cadre extérieur **8** représenté à la figure 2. L'Homme du métier peut sélectionner une multitude de formes différentes pour le cadre extérieur à condition que sa masse représente un pourcentage inférieur à 50% de la masse totale de la masse mobile, et plus particulièrement, que la masse du cadre extérieur soit significativement plus faible que celle du corps intérieur de la masse mobile.

Le capteur de force représenté sur la figure 3 possède des butées latérales se présentant sous la forme d'excroissances convexes **139,** situées à proximité de la zone d'ancrage **14,** en regard des flancs latéraux de la masse mobile. Ces butées latérales **139** peuvent servir de guidage à la masse mobile, pour limiter davantage ses déplacements suivant l'axe x. De manière analogue, des butées supplémentaires **129** formées d'excroissances convexes peuvent être disposées de part et d'autre de la butée **119** située à l'extrémité opposée à la zone d'ancrage **14.** Ces butées supplémentaires **129** représentent une sécurité supplémentaire pour arrêter le corps intérieur **111** de la masse mobile lors de déplacements trop importants suivant l'axe y.

Comme représenté sur la figure 3, la butée **119** peut avantageusement comporter des flancs latéraux convexes. Dans ce mode de réalisation, l'évidement réalisé dans le corps intérieur **111** de la masse mobile possède une forme sensiblement complémentaire à celle de la butée **119.** Les parties convexes de la butée **119** ne sont pas en regard d'un évidement de forme concave complémentaire sur le schéma de la figure 3, mais peuvent l'être selon d'autres modes de réalisation non représentés. L'emploi de parties convexes sur les flancs latéraux de la butée **119** et sur ceux de la masse mobile en vis-à-vis permet d'éviter d'endommager le corps intérieur **111** de la masse mobile lors de déplacements selon l'axe y entraînant un choc de la masse mobile contre la butée **119.**

Selon un mode de réalisation particulier, représenté à la figure 5, il est envisageable de combiner une ou plusieurs paires de ressorts de découplage orientés suivant les axes x et y, de manière à autoriser un découplage des déplacements intervenant à la fois dans le plan suivant l'axe x et suivant l'axe y. Des butées **229** sont avantageusement disposées en regard de deux côtés adjacents de la masse mobile.

La figure 6 illustre une variante de réalisation employant deux ressorts de découplage **337, 307** de nature différente, à savoir des poutres en flexion **307,** reliant le corps intérieur **311** de la masse mobile au cadre extérieur **38** de la masse mobile à proximité de l'extrémité du corps intérieur **311** de la masse mobile opposée à la zone d'ancrage **34** ; et un ressort de découplage **337** dit « ressort en accordéon ». Ce ressort de découplage **337** se présente sous la forme d'au moins quatre segments reliés entre eux de manière à former une structure en losange, connectée par deux extrémités opposées d'une part au cadre extérieur **38** et d'autre part au corps intérieur **311** de la masse mobile. Ce ressort de découplage « en accordéon » **337** est configuré de manière à ce que les connexions au corps intérieur **311** et au cadre extérieur **38** soient alignés suivant l'axe y.

La figure 7 propose un cinquième mode de réalisation du capteur de force objet de l'invention, dans lequel les deux extrémités suivant l'axe y du corps intérieur **411** de la masse mobile sont reliées au cadre extérieur **48** par des ressorts de découplage « en accordéon » **437**. Des butées **429** en forme de piliers ancrés dans le substrat **5** sont agencées à l'intérieur d'un évidement réalisé dans le corps intérieur **411** de la masse mobile.

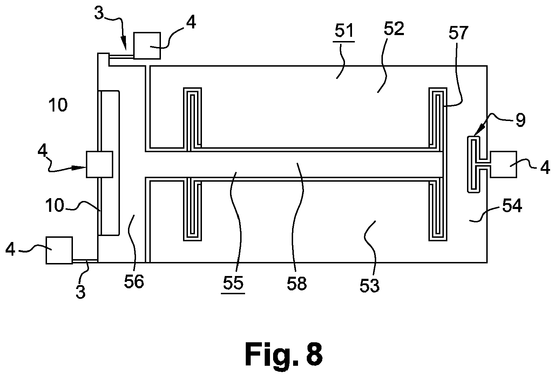

Une construction alternative est représentée à la figure 8, où les positionnements relatifs du corps principal **51** et de la structure porteuse **58** ont été inversés par rapport au mode de réalisation de la figure 2. Plus précisément, la structure porteuse **55** se présente sous la forme d'une poutre centrale 58 s'étendant perpendiculairement depuis la poutre transversale **56** elle-même reliée aux zones d'ancrage **4**. Le corps principal **51** est réparti autour de cette poutre centrale **58**, et présente deux portions latérales **52, 53**, reliées à leurs extrémités opposées aux zones d'ancrage 4 par une portion transverse **54**. Les ressorts **57** sont répartis symétriquement sur les faces le long de la poutre centrale **58,** et relient cette poutre centrale aux portions latérales **52, 53** du corps principal. A l'instar du mode de réalisation de la figure 2, la butée **9** comprend un ancrage **4** au substrat, et est disposée à l'intérieur d'un évidement réalisé dans la poutre transverse **54** du corps principal **51** de la masse mobile. Bien entendu, le positionnement central ou périphérique du corps principal peut se décliner pour les différents modes de réalisation décrits ci-dessus.

L'invention présentée ci-avant permet donc d'apporter les avantages suivants :

-   protéger les jauges de contrainte d'un capteur de force à déplacements hors du plan des sollicitations mécaniques intervenant dans le plan,
-   garantir une sensibilité mécanique élevée du capteur de force,
-   autoriser un mouvement solidaire hors plan, d'un corps intérieur et d'un cadre extérieur formant une masse mobile, ces deux entités étant en permanence sensiblement dans un même plan,
-   découpler les déplacements dans le plan du corps intérieur de ceux d'un cadre extérieur d'une masse mobile, grâce à des ressorts de découplage autorisant les déplacements relatifs du corps intérieur par rapport au cadre extérieur dans le plan.

**Revendications**

**1.** Dispositif micro-électromécanique réalisé à partir d'un substrat semi-conducteur dont les couches définissent des plans suivant des axes x et y, l'axe perpendiculaire aux couches définissant un axe z, ledit dispositif comprenant :

- au moins une zone d'ancrage fixe (4, 14, 24, 34, 44) par rapport au substrat,
- au moins une masse mobile, apte à se déplacer hors du plan du substrat selon l'axe z par rotation autour d'un axe de pivotement dirigé selon l'axe x,
- au moins un élément déformable (10, 110, 210, 310, 410), ledit élément déformable (10, 110, 210, 310, 410) reliant la masse mobile à la zone d'ancrage (4, 14, 24, 34, 44), et
- au moins un moyen de détection (3) du déplacement de la masse mobile, la masse mobile présentant une première partie formant une structure porteuse (8, 18, 28, 38, 48) et une seconde partie formant le corps principal (11, 111, 211, 311, 411) de la masse mobile, ladite première partie (8, 18, 28, 38, 48) étant reliée à la zone d'ancrage par l'élément déformable (10, 110, 210, 310, 410), lesdites première et deuxième parties (11, 111, 211, 311, 411) étant reliés par au moins deux portions flexibles (7, 117, 217, 227, 307, 337, 437) formant ressorts de découplage solidaires de deux côtés distincts de ladite première partie (8, 18, 28, 38, 48) et **caractérisé en ce qu'**il comporte au moins une butée (9, 119, 229, 309) limitant le déplacement de la seconde partie (11, 111, 211, 311) de la masse mobile par rapport à la zone d'ancrage.

**2.** Dispositif selon la revendication 1, **caractérisé en ce que** la première partie forme un cadre entourant la seconde partie formant le corps principal de la masse mobile.

**3.** Dispositif selon la revendication 1, **caractérisé en ce que** la seconde partie formant le corps principal de la masse mobile est disposée en périphérie de la première partie.

**4.** Dispositif selon la revendication 1, **caractérisé en ce que** les portions flexibles (7, 117) sont espacées d'une distance selon l'axe y supérieure à la moitié de la longueur selon l'axe y du corps intérieur (11, 111) de la masse mobile.

**5.** Dispositif selon la revendication 1, **caractérisé en ce que** les portions flexibles (7, 307) sont des poutres déformables en flexion.

**6.** Dispositif selon la revendication 1, **caractérisé en ce que** les portions flexibles (117, 217, 227, 337, 437) comportent plusieurs segments consécutifs présentant un angle non nul de l'un à l'autre.

**7.** Dispositif selon la revendication 1, **caractérisé en ce que** le dispositif comprend au moins quatre portions flexibles (7), lesdites portions flexibles (7) étant disposées deux à deux en regard l'une de l'autre.

8. Dispositif selon l'une quelconque des revendications précédentes, *caractérisé* **en ce que** la butée (9, 119, 229, 309) pour le corps principal (11, 111, 211, 311) de la masse mobile est disposée en regard du côté de la masse mobile situé à l'opposé de la zone d'ancrage (4, 14, 24, 34).

9. Dispositif selon l'une quelconque des revendications précédentes, *caractérisé* **en ce que** la butée (429) pour le corps principal (411) de la masse mobile est un pilier ancré sur le substrat et aménagé dans un évidement du corps principal (411) de la masse mobile.

10. Dispositif selon la revendication 8, *caractérisé* **en ce que** la butée (9, 119, 309) a une forme en T en vue de dessus.

11. Dispositif selon l'une quelconque des revendications 8 à 10, *caractérisé* **en ce que** les flancs latéraux de la butée (119) présentent des parties convexes.

12. Dispositif selon l'une des revendications 8 à 11, *caractérisé* **en ce que** le corps principal (11, 111, 311, 411) de la masse mobile présente un évidement de forme sensiblement complémentaire à celui de la butée (9, 119, 309, 429).

13. Dispositif selon l'une des revendications 8 à 11, *caractérisé* **en ce que** des butées latérales (139) sont agencées en regard des flancs latéraux de la masse mobile.

14. Dispositif selon la revendication 13, *caractérisé* **en ce que** les butées latérales (139) présentent des excroissances de forme arrondie.

15. Dispositif selon l'une quelconque des revendications précédentes, *caractérisé* **en ce qu'**il comprend au moins une première portion flexible (217) suivant l'axe x et au moins une seconde portion flexible (227) suivant l'axe y.

**Patentansprüche**

1. Mikroelektromechanische Vorrichtung, die ausgehend von einem Halbleitersubstrat ausgeführt ist, dessen Schichten Ebenen entlang der x- und y-Achse definieren, die zu den Schichten senkrechte Achse eine Achse z definiert, wobei diese Vorrichtung umfasst:

- mindestens eine Verankerungszone (4, 14, 24, 34, 44), die bezogen auf das Substrat fest ist,

- mindestens eine bewegliche Masse, die in der Lage ist, sich entsprechend der z-Achse außerhalb der Ebene des Substrats, durch Rotation um eine Schwenkachse zu bewegen, die entlang der x-Achse geführt wird,
- mindestens ein verformbares Element (10, 110, 210, 310, 410), wobei dieses verformbare Element (10, 110, 210, 310, 410) die bewegliche Masse mit der Verankerungszone (4, 14, 24, 34, 44) verbindet, und
- mindestens eine Vorrichtung zum Erfassen (3) der Bewegung der beweglichen Masse,

wobei die bewegliche Masse einen ersten Teil, der eine Rahmenstruktur (8, 18, 28, 38, 48) bildet und einen zweiten Teil aufweist, der den Hauptkörper (11, 111, 211, 311, 411) der beweglichen Masse bildet, wobei dieser erste Teil (8, 18, 28, 38, 48) über das verformbare Element (10, 110, 210, 310, 410) mit der Verankerungszone verbunden ist, wobei dieser erste und zweite Teil (11, 111, 211, 311, 411) über mindestens zwei flexible Abschnitte (7, 117, 217, 227, 307, 337, 437) miteinander verbunden sind, die Entkopplungsfedern bilden, die auf zwei unterschiedlichen Seiten dieses ersten Teils (8, 18, 28, 38, 48) fest verbunden sind und *dadurch gekennzeichnet, dass* sie mindestens einen Anschlag (9, 119, 229, 309) enthält, der die Verschiebung des zweiten Teils (11, 111, 211, 311) der mobilen Masse bezogen auf die Verankerungszone begrenzt.

2. Vorrichtung gemäß Anspruch 1, *dadurch gekennzeichnet, dass* der erste Teil einen Rahmen bildet, der den zweiten Teil, der den Hauptkörper der mobilen Masse bildet, umgibt.

3. Vorrichtung gemäß Anspruch 1, *dadurch gekennzeichnet, dass* der zweite Teil, der den Hauptkörper der mobilen Masse bildet, an der Peripherie des ersten Teils angeordnet ist.

4. Vorrichtung gemäß Anspruch 1, *dadurch gekennzeichnet, dass* die flexiblen Abschnitte (7, 117) in einem Abstand entlang der y-Achse angeordnet sind, der größer ist als die Hälfte der Länge entlang der y-Achse des Innenkörpers (11, 111) der beweglichen Masse.

5. Vorrichtung gemäß Anspruch 1, *dadurch gekennzeichnet, dass* es sich bei den flexiblen Abschnitten (7, 117) um biegeverformbare Balken handelt.

6. Vorrichtung gemäß Anspruch 1, *dadurch gekennzeichnet, dass* die flexiblen Abschnitte (117, 217, 227, 337, 437) mehrere aufeinanderfolgende Segmente enthalten, die einen Winkel ungleich Null zueinander aufweisen.

**7.** Vorrichtung gemäß Anspruch 1, *dadurch gekennzeichnet, dass* die Vorrichtung mindestens vier flexible Abschnitte (7) enthält, wobei diese flexiblen Abschnitte (7) jeweils zwei und zwei, einer gegenüber dem anderen angeordnet sind.

**8.** Vorrichtung nach einem der vorangehenden Ansprüche, *dadurch gekennzeichnet, dass* der Anschlag (9, 119, 229, 309) für den Hauptkörper (11, 111, 211, 311) der beweglichen Masse gegenüber der Seite der beweglichen Masse, die gegenüber der Verankerungszone (4, 14, 24, 34) liegt, angeordnet ist.

**9.** Vorrichtung nach einem der vorangehenden Ansprüche, *dadurch gekennzeichnet, dass* der Anschlag (429) für den Hauptkörper (411) der beweglichen Masse ein im Substrat verankerter Pfeiler ist, der in einer Aussparung des Hauptkörpers (411) der beweglichen Masse angeordnet ist.

**10.** Vorrichtung gemäß Anspruch 8, *dadurch gekennzeichnet, dass* der Anschlag (9, 119, 309) von oben gesehen eine T- Form hat.

**11.** Vorrichtung nach einem der vorangehenden Ansprüche 8 bis 10, *dadurch gekennzeichnet, dass* die Seitenflächen des Anschlags (119) konvexe Teile aufweisen.

**12.** Vorrichtung nach einem der vorangehenden Ansprüche 8 bis 11, *dadurch gekennzeichnet, dass* der Hauptkörper (11, 111, 311, 411) der beweglichen Masse eine Aussparung aufweist, deren Form im Wesentlichen komplementär zu der des Anschlags (9, 119, 309, 429) ist.

**13.** Vorrichtung nach einem der vorangehenden Ansprüche 8 bis 11, *dadurch gekennzeichnet, dass* seitliche Anschläge (139) gegenüber der Seitenwände der beweglichen Masse angeordnet sind.

**14.** Vorrichtung gemäß Anspruch 13 , *dadurch gekennzeichnet,* **dass** die seitlichen Anschläge (139) abgerundete Vorsprünge aufweisen.

**15.** Vorrichtung nach einem der vorangehenden Ansprüche 8 bis 11, *dadurch gekennzeichnet, dass* sie mindestens einen ersten flexiblen Abschnitt (217) entlang der x-Achse und mindestens einen zweiten Abschnitt (227) entlang der y-Achse enthält.

**Claims**

**1.** A micro-electromechanical device formed from a semiconductor substrate having its layers defining planes along axes x and y, the axis perpendicular to the layers defining an axis z, said device comprising:

- at least one anchoring area (4, 14, 24, 34, 44) which is fixed with respect to the substrate,
- at least one mobile mass, capable of displacing out of the substrate plane along axis z by rotation around a swivel axis directed along axis x,
- at least one deformable element (10, 110, 210, 310, 410), said deformable element (10, 110, 210, 310, 410) connecting the mobile mass to the anchoring area (4, 14, 24, 34, 44), and
- at least one means for detecting (3) the displacement of the mobile mass,
- said mobile mass having a first portion forming a support structure (8, 18, 28, 38, 48) and a second portion forming the main body (11, 111, 211, 311, 411) of the mobile mass, said first portion (8, 18, 28, 38, 48) being connected to the anchoring area by the deformable element (10, 110, 210, 310, 410), said first and second portions (11, 111, 211, 311, 411) being connected by at least two flexible portions (7, 117, 217, 227, 307, 337, 437) forming decoupling springs fastened to two different sides of said first portion (8, 18, 28, 38, 48);

**characterized in that** it comprises at least one stop (9, 119, 229, 309) limiting the displacement of the second portion (11, 111, 211, 311) of the mobile mass relative to the anchoring area.

**2.** The device of claim 1, *characterized in that* the first portion forms a frame surrounding the second portion forming the main body of the mobile mass.

**3.** The device of claim 1, *characterized in that* the second portion forming the main body of the mobile mass is arranged at the periphery of the first portion.

**4.** The device of claim 1, *characterized in that* the flexible portions (7, 117) are spaced apart by a distance along axis y greater than half the length along axis y of the inner body (11, 111) of the mobile mass.

**5.** The device of claim 1, *characterized in that* the flexible portions (7, 307) are flexibly-deformable beams.

**6.** The device of claim 1, *characterized in that* the flexible portions (117, 217, 227, 337, 437) comprise a plurality of consecutive segments having a non-zero angle relative to one another.

**7.** The device of claim 1, *characterized in that* the device comprises at least four flexible portions (7), said flexible portions (7) being arranged two by two opposite each other.

**8.** The device of any of the foregoing claims, *charac-*

**terized in that** the stop (9, 119, 229, 309) for the main body (11, 111, 211, 311) of the mobile mass is arranged in front of the side of the mobile mass located opposite to the anchoring area (4, 14, 24, 34).

9. The device of any of the foregoing claims, **characterized in that** the stop (429) for the main body (411) of the mobile mass is a pillar anchored on the substrate and fitting into a recess of the main body (411) of the mobile mass.

10. The device of claim 8, **characterized in that** the stop (9, 119, 309) has a T shape in top view.

11. The device of any of claims 8 to 10, **characterized in that** the lateral sides of the stop (119) have convex portions.

12. The device of any of claims 8 to 11, **characterized in that** the main body (11, 111, 311, 411) of the mobile mass has a recess with a shape substantially complementary to that of the stop (9, 119, 309, 429).

13. The device of any of claims 8 to 11, **characterized in that** lateral stops (139) are arranged opposite the lateral sides of the mobile mass.

14. The device of claim 13, **characterized in that** said lateral stops (139) have projections of rounded shape.

15. The device of any of the foregoing claims, **characterized in that** it comprises at least one first flexible portion (217) along axis x and at least one second flexible portion (227) along axis y.

**Fig. 1**

**Fig. 2**

**Fig. 3**

**Fig. 4**

**Fig. 5**

**Fig. 6**

**Fig. 7**

**Fig. 8**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4736629 A
- FR 2954505
- FR 2941533
- EP 2367015 A